## Europäisches Patentamt

## European Patent Office

## Office européen des brevets

(19)

(11) Numéro de publication: **0 245 188**
**A2**

(12) # DEMANDE DE BREVET EUROPEEN

(21) Numéro de dépôt: **87450010.1**

(51) Int. Cl.⁴: **H 05 K 3/34**

(22) Date de dépôt: **16.04.87**

(30) Priorité: **28.04.86 FR 8606236**

(43) Date de publication de la demande: **11.11.87 Bulletin 87/46**

(84) Etats contractants désignés: **AT BE CH DE ES FR GB GR IT LI LU NL SE**

(71) Demandeur: **Société Talco, Avenue Negrepelisse BP 357, F-82003 Montauban (FR)**

(72) Inventeur: **Bourrières, Francis, Société Talco Avenue de Nègrepelisse, BP 357 F-82003 Montauban (FR)**

(74) Mandataire: **Ravina, Bernard, Cabinet Bernard RAVINA 24, boulevard Riquet, F-31000 Toulouse (FR)**

(54) **Procédé de brasage de composants de surface sur une carte imprimée.**

(57) La présente invention concerne un procédé de brasage de composants de surface sur une carte imprimée.

Le procédé de brasage de composants de surface sur une carte imprimée selon l'invention concerne le brasage selon lequel la crème à braser, constituée par des microbilles en alliage à braser liées par un flux leur donnant une forme pâteuse, est étalée par exemple par sérigraphie sur les endroits où le brasage est à effectuer, les composants de surface sont, manuellement ou automatiquement, positionnés sur la dite carte, sa température est montée par un moyen quelconque, jusqu'à une température plus élevée que celle de la fusion de l'alliage à braser et enfin cette carte est refroidie pour permettre la solidification des soudures, ce procédé se caractérise en ce que la dite carte est, en vue de déplacer les microbilles formées et dispersées d'une façon aléatoire sur elle, mise en contact, pour une période prédéterminée, avec un liquide de surfusion dont la température est plus élevée que celle de fusion de l'alliage à braser, ceci pour faire fondre d'une manière préférentielle les dites microbilles dont le rapport surface exposée/volume est beaucoup plus important que celui des soudures elles-mêmes donnant ainsi la chance aux dites microbilles de se déplacer, selon leur emplacement sur la carte imprimée et suivant les tensions de surface agissant localement, soit vers les parties métalliques de la dite carte soit vers le liquide de surfusion, cette deuxième fusion étant suivie par un refroidissement.

La présente invention concerne un procédé et une installation de brasage. Elle concerne particulièrement le brasage de composants de surface sur une carte imprimée.

L'invention concerne plus précisément le brasage effectué à l'aide d'une crème à braser constituée de microbilles liées par un flux leur donnant une forme pâteuse. Ces microbilles constituent l'alliage à braser, elles peuvent avoir comme composition, par exemple l'étain, le plomb et éventuellement d'autres métaux dans les proportions habituellement utilisées. Le flux assure le lien des dites microbilles et prépare comme il est connu les surfaces à souder.

A l'heure actuelle, la tendance à utiliser cette crème à braser augmente. Ceci grâce à la facilité de son application effectuée habituellement par sérigraphie et aussi à la facilité du contrôle de l'épaisseur de la couche déposée.
Le désavantage de cette technique de brasage est la formation de microbilles dispersées d'une façon aléatoire sur la carte.

Ces microbilles peuvent selon leur taille et leur emplacement sur la carte imprimée, établir des courts circuits entre les différentes connexions ou avoir d'autres effets indésirables comme par exemple les effets capacitifs. La formation de ces microbilles n'est pas expliquée avec certitude.

D'une manière générale, on peut admettre que la différence de la température de fusion entre le flux et l'alliage à braser,sous la forme de microbilles,peut avoir comme résultat la fusion du flux voire presque l'ébullition avant ou pendant la fusion de microbilles. Le flux interstitiel, thermiquement agité peut,en essayant de s'échapper,entraîner en éclats la matière métallique fondue ou non, formant ainsi les dites microbilles très génante à l'heure actuelle.

On connait actuellement des essais qui visent à maitriser ces éclaboussements de la matière métallique, ceci en régularisant la montée en température. Dans ces essais on a trouvé qu'une montée lente en température, c'est a dire étalée dans le temps, jusqu'avant la température de fusion de l'alliage métallique permet de laisser le flux s'échapper en état moins agité.

Les désavantages de cette technique sont:
- la possibilité permanente de la formation de microbilles en quantité relativement inférieure;
- la lenteur du processus de brasage.

Pour ces raisons la présente invention dans le but de pallier les inconvénients ci-dessus cités, propose un procédé et une installation de brasage de composants de surface sur une carte imprimée. Selon le procédé faisant partie de l'invention et suivant une disposition, la crème à braser est, comme il est actuellement pratiqué, étalée par exemple par sérigraphie, sur les endroits où le brasage est à effectuer, les composants de surface sont ,manuellement ou automatiquement, positionnés sur la dite carte, sa température est montée par un moyen quelconque, jusqu'à une température plus élevée que celle de la fusion de l'alliage à braser et enfin cette carte est refroidie pour permettre la solidification des soudures. Le procédé se caractérise essentiellement en ce que la dite carte est, en vue de déplacer les microbilles formées pendant le brasage, mise en contact avec un liquide de surfusion dont la température est plus élevée que celle de fusion de l'alliage à braser, ceci pour faire fondre d'une manière préférentielle les dites microbilles dont le rapport surface exposée/volume est beaucoup plus important que celui des soudures elles-mêmes, donnant ainsi la chance aux dites microbilles de se déplacer, selon leur emplacement sur la carte imprimée et suivant les tensions de surface agissant localement, soit vers les parties metalliques de la carte soit vers le liquide de surfusion cette deuxième fusion étant suivie par un refroidissement.

Suivant une autre disposition, l'installation pour la mise en oeuvre du procédé, se caractérise essentiellement par:

- un bac de liquide de surfusion, chauffé à une température supérieure à celle de fusion de l'alliage à braser, muni d'un moyen pour créer des vagues de liquides de surfusion,
- un moyen de transport muni d'organes pour tenir les cartes imprimées, ce moyen avance à une cadence continue ou discontinue exposant les dites cartes dont la surface à traiter est dirigée vers le bas, l'une aprés l'autre aux dites vagues,
- un compartiment de refroidissement postérieur au dit bac à vagues.

La présente invention sera mieux comprise à la lecture de la description détaillée ci-aprés, accompagnée d'un dessin représentant schématiquement l'installation pour la mise en oeuvre du procédé.

Comme il a été précisé, ci avant, le brasage de composants de surface, à l'aide de la crème à braser, sur une carte imprimée, offre plusieurs avantages. Par contre la formation de microbilles, constatée toujours lors du dit brasage, présente un handicap serieux pour la qualité du produit fini.

Ceci cause le rejet d'un pourcentage plus ou moins élevé de cartes imprimées finies, notamment pour celles portant des composants à pattes multiples rapprochées.

Selon le procédé faisant partie de la présente invention, le brasage proprement dit est d'abord effectué à l'aide d'un quelconque des moyens connus: la crème à braser est d'abord appliquée sur les emplacements de pattes de composants de surface, ces composants y sont positionnés, la température est élevée jusqu'à la fusion de l'alliage à braser contenu dans la dite crème sous la forme de microbilles et enfin la carte imprimée est refroidie pour permettre la solidification de soudures. La carte imprimée ainsi réalisée est, par la suite, mise en contact pour une période déterminée, avec un liquide de surfusion chauffé à une température plus élevée que celle de fusion de l'alliage à braser et enfin la dite carte est refroidie. Il est à noter que cette deuxièmer fusion peut être répétée.

La période pendant laquelle la dite carte est mise en contact avec le liquide de surfusion doit être suffisante pour faire fondre les microbilles à déplacer, par contre elle ne doit pas être assez longue pour faire fondre, en profondeur, les soudures elles-mêmes. En effet, les microbilles formées ont, en général, un volume beaucoup moins important que celui des soudures elles mêmes, ce qui veut dire que ces microbilles ont une surface exposée par rapport à leur volume beaucoup plus important que celles des soudures proprement dites.

Donc il est facile d'admettre qu'en mettant en contact la carte imprimée avec un liquide de surfusion, ces microbilles, dont le rapport surface exposée/volume est beaucoup plus important que celui des soudures, fondant avant les dites soudures.

Plusieurs facteurs peuvent jouer un rôle sur le déplacement de ces microbilles en contact avec le liquide de surfusion chauffé:
- les tensions de surface agissant localement dans l'environnement de chaque microbille, suivant son emplacement, à savoir: microbille-liquide, microbille-surface non-métallisée, microbille-surface métallisée ( pistes de connexion ou soudures), microbilles-autres surfaces faisant partie de composants de surface.
- l'agitation thermique et éventuellement mécanique du liquide de surfusion.
- les forces agissant verticalement sur chaque microbille, prévisibles à partir de sa taille, sa densité, la densité de liquide de surfusion.

Le déplacement recherché pour une microbille est soit vers une partie métallique de la carte soit vers le liquide lui-même, c'est-à-dite l'enlèvement de cette microbille.

Dans le premier cas, c'est-à-dire dans le cas d'un déplacement vers une partie métallique, la microbille s'étale sur la dite partie de même nature qu'elle ou d'une nature proche, de telle sorte que la tension de surface pour l'ensemble microbille-surface métallique soit minimale. Pour obtenir un tel résultat la dite microbille doit venir suffisamment en contact avec cette partie métallique, ceci peut être favorisé par l'agitation mécanique du liquide de surfusion, cette agitation mécanique vient s'ajouter à l'agitation thermique favorisant elle aussi l'agitation de la microbille et par conséquent son éventuelle approche d'une partie métallique.

Des pistes métalliques fictives, c'est-à-dire en dehors des connexions fonctionnelles de circuit, peuvent être effectuées, sur la carte imprimée, pour piéger une partie de microbilles agitées et suffisamment proches d'elles.

Dans le deuxième cas, c'est-à-dire dans le cas de déplacement vers le liquide, la microbille est enlevée et entourée entièrement par le dit liquide de surfusion. Comme pour le cas précédent, l'agitation mécanique, ajoutée à l'agitation thermique du liquide peut aider à l'enlèvement de ces microbilles. En effet les facteurs décisifs, dans ce cas, sont le pouvoir de mouillage de liquide de surfusion sur les microbilles et également les forces agissant verticalement sur elles; le liquide doit pouvoir mouiller les microbilles et la résultante des forces agissant verticalement doit agir dans le sens d'arrachement des dites microbilles de la surface. Pour ces raisons le choix de, ou des additifs à ajouter dans, ce liquide doivent favoriser le mouillage de microbilles. Egalement, vu que la matière des microbilles est plus dense que le dit liquide, la surface de la carte à traiter doit, de préférence, être dirigée vers le bas.

Pour éliminer des éventuels effets favorisant l'accrochage entre les microbilles et la surface de la carte, la dite surface est à l'issue de chaque fusion doit être lavée pour éliminer le reste de flux dénaturé, ceci facilite l'enlèvement des microbilles des endroits non métalliques.

Pour favoriser l'étalement des microbilles, suffisamment proches des parties métalliques, sur la surface de ces parties ( pistes de connexion ou soudures), il est préférable de traiter la surface de la carte imprimée après l'avoir nettoyée, par un flux liquide. Ceci aide, lors de la fusion des microbilles à leur étalement sur les surfaces métalliques soit de soudures superficiellement fondues soit de piste de connexion.

Il est à noter que le brasage lui même peut être effectué dans un milieu liquide de surfusion. Ceci peut diminuer la chance de formation de microbilles, mais vu l'existence du flux déja dénaturé s'échappant de la crème à braser et salissant la surface de la carte imprimée, les conditions d'enlèvement de certaines microbilles ne sont pas favorables.
Il est également à noter que lors du brasage et pour ne pas risquer le déplacement des composants de surface eux-mêmes, la durée pendant laquelle l'alliage à braser est en fusion, doit être minimisée, ceci ne favorise pas non plus l'enlèvement de certaines microbilles. Enfin, pendant le brasage, il est risqué de présenter la carte imprimée avec sa surface à traiter dirigée vers le bas.

Dans le procédé qu'on vient de détailler, on a décrit le brasage de composants de surface sur une carte imprimée. Il va de soi que le dit brasage peut s'effectuer sur un support quelconque soit pour des composants de surface soit pour d'autres éléments à braser de la même manière.

Il est à noter que le flux liant les microbilles ou le flux de liquide sont de type connu.

8 0245188

L'installation de brasage selon l'invention peut être présentée comme une chaîne de brasage. Les cartes imprimées (6) sont posées sur un moyen de transport (11) comme par exemple un tapis roulant. Sur ces cartes, la crème à braser est préalablement appliquée et également les composants de surface sont positionnés. L'opération de brasage proprement dite peut être effectuée à l'aide des sources de chaleur comme par exemple des émetteurs d'infra-rouge (12). Ces émetteurs peuvent être positionnés à proximité du moyen de transport (11) et couverts par un tunnel (13) isolant pour éviter la perte de chaleur.

A la sortie du tunnel de brasage les cartes imprimées sont refroidies dans un compartiment de refroidissement (14) à l'aide, par exemple, des hélices qui renouvellent l'air au dessus de ces cartes.

Les cartes imprimées avancent pour être lavées et rincées: d'abord dans un compartiment de lavage (16) puis dans un compartiment de rinçage (17). Le compartiment de lavage comporte un bac (18) muni d'une évacuation par trop plein (19). Plusieurs buses (20) éjectent l'eau ou un autre solvant convenable sur les cartes qui avancent sur un moyen de transport (5), un réservoir (21) destockage distribue un détergent à un débit convenable sur les dites cartes, des brosses (22) rotatives agissent sur les surfaces supérieures des cartes où les composants sont soudés.
Une pompe (23) peut être utilisée pour l'alimentation des buses (22). Un couvercle (24) de protection couvre le bac (18) sans toucher les cartes (6). Une eventuelle unité de chauffe (43) peut être utilisée pour faire chauffer le bac de lavage. Le compartiment de rinçage (17) est muni de buses (25) qui éjectent l'eau ou un solvant convenable sur les cartes imprimées.

Les cartes, depuis l'entrée (A), ou depuis la sortie du compariment (14),sont maintenues sur le moyen de transport par des organes non présentés.

Le moyen(5) de transport avance, à la sortie du compartiment (17) verticalement vers le bas, puis se redresse pour avancer de nouveau, horizontalement, avec les faces de cartes imprimées dirigées vers le bas.

Sur la partie verticale de passage du moyen de transport (5) se trouve un compartiment de séchage (28). Ce compartiment de séchage (28) comprend des buses (29) qui soufflent l'air sur les surfaces des dites cartes en vue de les sécher, un capot de protection (30) muni d'un échappement supérieur (31).

Au début de la partie horizontale du moyen de transport (5), se trouve un compartiment (26) d'application de flux liquide sur les faces des cartes imprimées.

Ce compartiment est constitué par un bac (32) de flux muni d'un moyen (27) créant des vagues du dit flux. Ce moyen (27) comporte une buse (33) et une pompe (34).

La pompe (34) pousse le flux pour qu'il jaillisse,par la buse sur la surface de liquide constituant ainsi les dites vagues. Un filtre (35) peut intercepter le circuit fermé de flux pour retenir des éventuelles microbilles se détachant,pendant l'application du flux, des surfaces des cartes imprimées.

A la suite du compartiment (26), se trouve un compartiment (10) de préchauffage muni d'éléments de chauffe (36).

A la suite du compartiment (10), se trouve un compartiment (37) de fusion. Ce compartiment est constitué par un bac (1) rempli d'un liquide de surfusion (4) et muni d'un moyen (40) de chauffe et d'un moyen (2) pour créer des vagues (3) du dit liquide. Le moyen (2) peut être constitué par une pompe (35) et une buse (39), la pompe (38) aspire le liquide de fusion par une conduite (9) du bac (1) pour le pousser dans la buse (39), le liquide jaillit sur la surface de liquide dans le bac (1) formant ainsi les vagues (3). Un filtre peut intercepter le circuit fermé de liquide pour retenir les microbilles détachées.

A la sortie du compartiment de fusion (37) se trouve un compartiment (7) de refroidissement identique au compartiment (14).

Un égouttoir (38) est placé sous le passage des cartes imprimées au niveau du compartiment (7) pour recevoir les gouttes tombant des dites cartes ou du moyen de transport et les conduire de nouveau dans le bac (1). Cet égouttoir peut être muni d'une buse (39) dont la sortie est d'une largeur égale ou supérieure à celle des cartes imprimées. Cette buse souffle l'air sous pression dont la direction est inclinée par rapport au plan de passage du moyen de transport et opposé à son sens d'avancement.

A la sortie du compartiment de refroidissement (7), se trouve un compartiment de rinçage (41) dont la conception est identique à celle du compartiment (17). Les buses du compartiment (41) éjectent un solvant pour enlever le reste du liquide de surfusion, ce solvant peut éventuellement être de l'eau.

Enfin, un compartiment de séchage (42) se trouve à la fin de la chaîne de brasage.

Le principe de conception du compartiment (42) est comparable à celui du compartiment (28).

A la sortie (B) de la chaine de brasage, se trouvent des moyens non présentés pour libérer les cartes imprimées du moyen de transport (5).

Il est à noter que l'installation de brasage qu'on vient de décrire est donnée à titre purement indicatif. Les moyens de transport (11) et (5) peuvent être remplacés par d'autres moyens connus, l'application du flux liquide peut être également effectuée de plusieurs manières, les moyens de refroidissement de lavage et de séchage peuvent être également remplacés par d'autres moyens connus ou à connaitre.

Il va de soi que d'autres installations peuvent être construites pour mettre en oeuvre le procédé revendiqué dans la présente demande sans sortir pour autant du cadre du présent brevet.

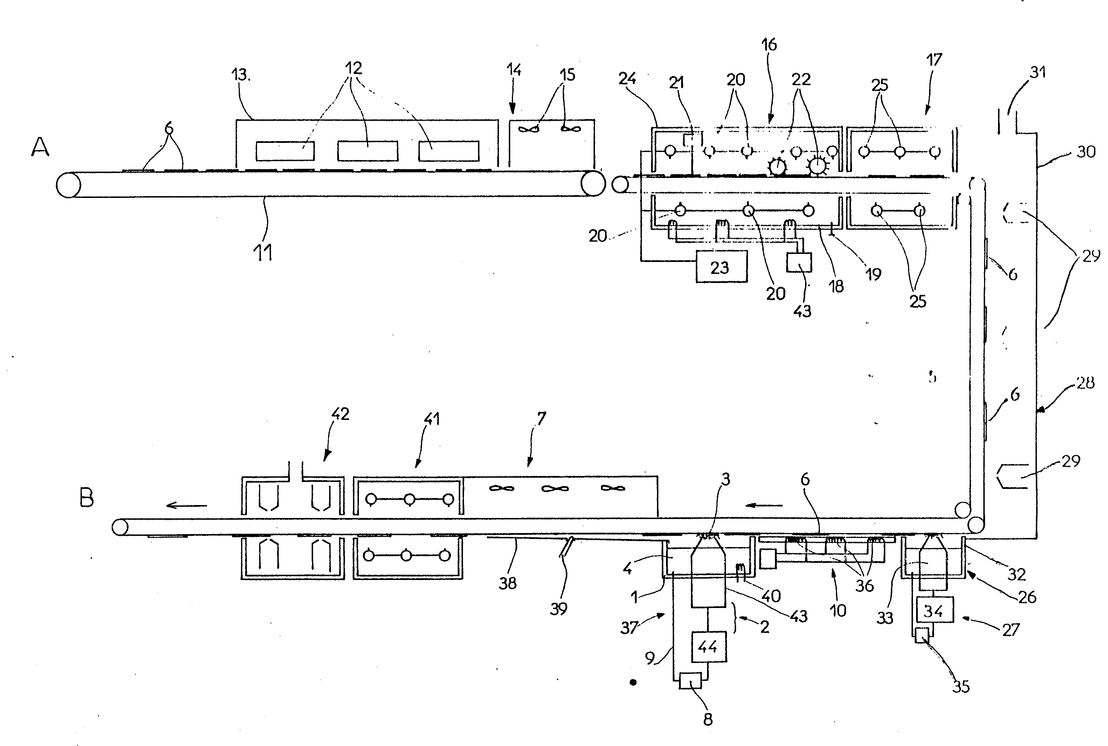

REVENDICATIONS

1. Procédé de brasage de composants de surface sur une carte imprimée selon lequel la crème à braser,constituée par des microbilles en alliage à braser liées par un flux leur donnant une forme pâteuse,est étalée par exemple par sérigraphie sur les endroits où le brasage est à effectuer les composants de surface sont, manuellement ou automatiquement, positionnés sur la dite carte, sa température est montée par un moyen quelconque, jusqu'à une température plus élevée que celle de la fusion de l'alliage à braser et enfin cette carte est refroidie pour permettre la solidification des soudures, procédé caractérisé en ce que la dite carte est en vue de déplacer les microbilles formées et dispersées d'une façon aléatoire sur elle, mise en contact,pour une période prédétrerminée avec un liquide de surfusion dont la température est plus élevée que celle de fusion de l'alliage à braser, ceci pour faire fondre d'une manière préférentielle les dites microbilles dont le rapport surface exposée/volume est beaucoup plus important que celui des soudures elles-mêmes donnant ainsi la chance aux dites microbilles de se déplacer,selon leur emplacement sur la carte imprimée et suivant les tensions de surface agissant localement soit vers les parties métalliques de la dite carte,soit vers le liquide de surfusion, cette deuxième fusion étant suivie par un refroidissement.

2. Procédé selon la revendication 1 caractérisé en ce que la deuxième fusion suivie d'un refroidissement peut être répétée pour, au moins une autre fois.

3. Procédé selon la revendication 1 ou la revendication 2 caractérisé en ce que le liquide de surfusion est, pendant la deuxième fusion et/ou les éventuelles fusions suivantes, mécaniquement agité.

4. Procédé selon les revendication 1, 2 ou 3 caractérisé en ce que la carte imprimée est pendant la deuxième fusion et/ou les éventuelles fusions suivantes exposée, au liquide de surfusion avec la surface à traiter, c'est-à-dire la surface sur laquelle les microbilles sont à déplacer, dirigée vers le bas.

5. Procédé selon l'une quelconque des revendications de 1 à 4 caractérisé en ce que la carte imprimée est, avant la deuxième fusion et/ou les éventuelles fusions suivantes lavées, ceci pour éliminer le reste d'éventuel flux dénaturé.

6. Procédé selon l'une des quelconques des revendications de 1 à 5 caractérisé en ce que la carte imprimée peut être traitée avec un flux de liquide,à la suite du lavage du flux dénaturé avant la deuxième fusion et/ou les éventuelles fusions suivantes.

7. Procédé selon l'une des quelconque revendications de 1 à 6 caractérisé en ce que la carte imprimée est munie de pistes métalliques fictives pour attirer certaines éventuelles microbilles et les canaliser.

8. Installation pour la mise en oeuvre du procédé selon les revendications 1, 3 et 4 caractérisé par:
- un bac (1) muni d'un moyen (2) pour créer des vagues (3) d'un liquide de surfusion (4) chauffé à une température supérieure à celle de fusion de l'alliage à braser,
- un moyen de transport (5) muni d'organes (non-présentés) pour maintenir les cartes imprimées (6), ce moyen de transport avance à

0245188

une cadence continue ou discontinue exposant les dites cartes dont la surface à traiter est dirigée vers le bas, l'une après l'autre aux dites vagues,

- un compartiment (7) de refroidissement postérieur au dit bac (1).

9. Installation selon la revendication 8 caractérisé par un filtre (8) mis dans un circuit fermé (9) du moyen créant les vagues pour retenir les microbilles libérées dans le liquide de surfusion.

10. Installation selon les revendications 5 et 8 caractérisée par un compartiment de préchauffage (10) antérieur au récipient (1) muni d'éléments de chauffe pour faire monter la température des cartes imprimées de telle sorte que le liquide de surfusion ne subisse pas beaucoup de refroidissement du au défilé des dites cartes.

11. Installation selon les revendications 8 et 10 caractérisé par un compartiment (26) pour appliquer le flux liquide sur les surfaces à traiter des cartes imprimées le dit compartiment se trouve avant le compartiment de préchauffage (10), la dite application du flux liquide est effectuée à l'aide d'un moyen (27) créant des vagues du dit flux à appliquer sur les surfaces des dites cartes dirigées vers le bas.

A

B

1/1

0245188